# EUROPEAN PATENT SPECIFICATION

(11) **EP 0 309 540 B1**
(45) Date of publication and mention of the grant of the patent: **06.10.1993**
(21) Application number: 88903514.3
(22) Date of filing: 07.03.1988
(51) Int. Cl.: C30B 15/34

(54) **AN APPARATUS AND PROCESS FOR EDGE-DEFINED, FILM-FED CRYSTAL GROWTH**
VORRICHTUNG UND VERFAHREN FÜR KANTENBESTIMMTES SCHMELZFILMBESCHICKTES KRISTALLZIEHEN
DISPOSITIF ET PROCEDE DE CROISSANCE DE CRISTAUX PAR ALIMENTATION DE COUCHE AVEC CONTROLE DE SURFACE

(30) Priority: 27.03.1987 US 31392
(43) Date of publication of application: 05.04.1989
(73) Proprietor: MOBIL SOLAR ENERGY CORPORATION, Billerica, MA 01821 (US)
(72) Inventor: HARVEY, David, S., Groton, MA 01450 (US)
(74) Representative: Kerr, Simonne June
(86) International application number: US8800698
(87) International publication number: WO8807598

(56) References cited:
- US-A- 3 701 636
- US-A- 3 846 082
- US-A- 4 118 197
- US-A- 4 230 674
- US-A- 4 415 401
- US-A- 4 440 728
- US-A- 4 443 411
- US-A- 4 544 528

## Description

This invention relates to crystal growing apparatus in general and more particularly to apparatus adapted to grow crystalline bodies according to the EFG ("Edge-defined, Film-fed Growth") process.

Various methods have been developed for growing crystalline bodies from a melt. One such method is known as the EFG process. Details of the EFG process and of apparatus for growing crystalline bodies according to the EFG process are described and illustrated in US-A-4544528 which discloses an apparatus for growing hollow tubular crystalline bodies from the melt using the edge-defined film-fed growth (EFG) technique. This growing takes place in a controlled atmosphere. Furthermore a cooling gas, like argon containing a small amount of oxygen is provided to the interior of the growing hollow tubular crystal body. As taught in the aforementioned U.S. Patent, such gas is conveyed to the interior, through the bore (76) in the stem (24). Surplus gas is vented through apertures (64) in seed holder (56) and apertures (78) in flange (74).

US-A-4415401 discloses the crystal growth of a flat ribbon using the EFG technique in which the liquid/solid interface is enveloped with a mixture of an inert gas and more than a trace amount of carbon-containing gas.

US-A-4443411 discloses a method and apparatus for using a gas mixture containing an additive gas capable of altering the physical or chemical properties of a crystallized body in the form of a flat ribbon grown from a melt using the EFG technique.

In the EFG process, a capillary-forming die member is placed in association with a melt of liquid source material so that a growth face on the die member is wetted with a liquid film of source material from the melt by capillary action. A product crystalline body is then grown by first introducing a seed crystal to the liquid film of source material so that crystal formation is initiated, and then drawing the seed crystal away from the growth face at a controlled rate so that the liquid film of source material remains sandwiched between the growing crystalline body and the growth face of the die member. Since the liquid film of source material on the die's growth face is continuously replenished from the melt by the die's one or more capillaries, continuous crystalline bodies of significant size may be grown from the melt.

One consequence of the EFG process described above is that the cross-sectional shape of the product crystalline body is determined by the shape of the growth face of the die member. As a result, by appropriately shaping the growth face of the die member, crystalline bodies may be grown which have the shape of a round rod (i.e. where the crystalline body has a cross-sectional shape which is that of a solid circle), a flat ribbon (i.e. where the crystalline body has a cross-sectional shape which is that of a solid rectangle), a hollow tube (i.e. where the crystalline body has an annular cross-section of circular, elliptical or polygonal shape), etc.

In practice, it has been found that significant improvements in crystal quality can be obtained if one can control the atmosphere surrounding the growing crystalline body. This is because control of the atmosphere surrounding the growing crystalline body allows harmful reactive gases to be removed from the area surrounding the growing crystalline body while allowing inert gases, beneficial reactive gases, and/or beneficial doping gases to be introduced to the area surrounding the growing crystalline body. In addition, control of the temperature of the atmosphere surrounding the growing crystalline body can facilitate proper regulation of the temperature of the growing crystalline body.

US-A-4415401, US-A-4443411 and the publication "Modeling Of Ambient-Meniscus Melt Interactions Associated With Carbon And Oxygen Transport In EFG Of Silicon Ribbon" by J.P. Kalejs and L.Y. Chin, published in the Journal Of The Electrochemical Society, Vol. 129, No. 6, June 1982, all teach ways of controlling the atmosphere surrounding a growing crystalline body where that body is a flat ribbon. Unfortunately, these references are silent as to how to control the atmosphere surrounding the growing crystalline body where that body is in the form of a hollow tube. In this respect, it is noted that the problems of controlling the atmosphere surrounding the growing crystalline body are magnified significantly in the case of apparatus adapted to grow hollow tubes, since in such apparatus the body of the growing hollow tube serves to effectively divide the atmosphere surrounding the growing crystalline body into an "exterior" zone (i.e. the zone located outside the growing crystalline body) and an "interior" zone (i.e. the zone located inside the growing crystalline body), because the walls of the growing crystalline body serve to prohibit the direct flow of gases between the "exterior" and "interior" zones and gases can only flow between the two zones by passing through the seed holder located at the remote end of the hollow crystalline body.

An object of the present invention is to provide a novel apparatus for growing tubular crystalline bodies according to the EFG process wherein the apparatus includes means for controlling the atmosphere surrounding the growing crystalline body; and further wherein the atmosphere in the exterior zone can be controlled independently of the atmosphere in the interior zone.

According to the present invention an apparatus for use in a system for growing hollow crystalline bodies of a selected cross-sectional shape from a source material according to the EFG process, of the type comprising a crucible-die assembly having means defining a crucible chamber for containing a supply of liquid source material, means defining a growth face for supporting a liquid film of source material for contact by a seed crystal for use in crystal growth and means defining at least one capillary for supplying liquid source material from the crucible chamber to the growth face so as to sustain said liquid film of source material by capillary action, the growth face when viewed in plan view having an annular configuration is characterized by an interior edge and an exterior edge, whereby a hollow tubular body may be grown from a liquid film of the source material on the growth face and support means for supporting the crucible-die assembly, characterized in that there is provided a first port associated with the support for defining a first gas inlet port and a first passage connected to the first port for directing gases introduced into the first port to the region adjacent the interior edge of the growth face, a second port for defining a second gas inlet port and a second passage connected to the second port for directing gases introduced via the second port to the region adjacent the exterior edge of the growth face, whereby inner and outer surfaces of a hollow body being grown from the liquid film will be contacted by gases discharged from the first and second passages respectively, at least part of the first and second passages being formed in at least part of the crucible-die assembly.

As used herein, the terms "tube" and "tubular" are to be construed in a generic sense to include enlongate hollow bodies having a circular, polygonal or other - e.g. elliptical - cross-sectional shape.

The invention will now be described further, by way of example, with reference to the accompanying drawings, in which:-
Fig. 1 is a sectional view of novel apparatus for growing tubular crystalline bodies according to the EFG process, wherein the apparatus incorporates a preferred embodiment of the present invention;
Fig. 2 is a top plan view of the crucible-die
assembly shown in Fig.1; Fig. 2A is a partial sectional view of the crucible-die assembly shown in Figs. 1 and 2;
Fig. 3 is a top plan view of the interior gas flow manifold shown in Fig. 1;
Fig. 4 is a sectional view taken along line 4-4 of Fig. 3;
Fig. 5 is a top plan view of the exterior gas flow manifold shown in Fig. 1; and
Fig. 6 is a sectional view taken along line 6-6 of Fig. 5.

### Detailed Description Of The Invention

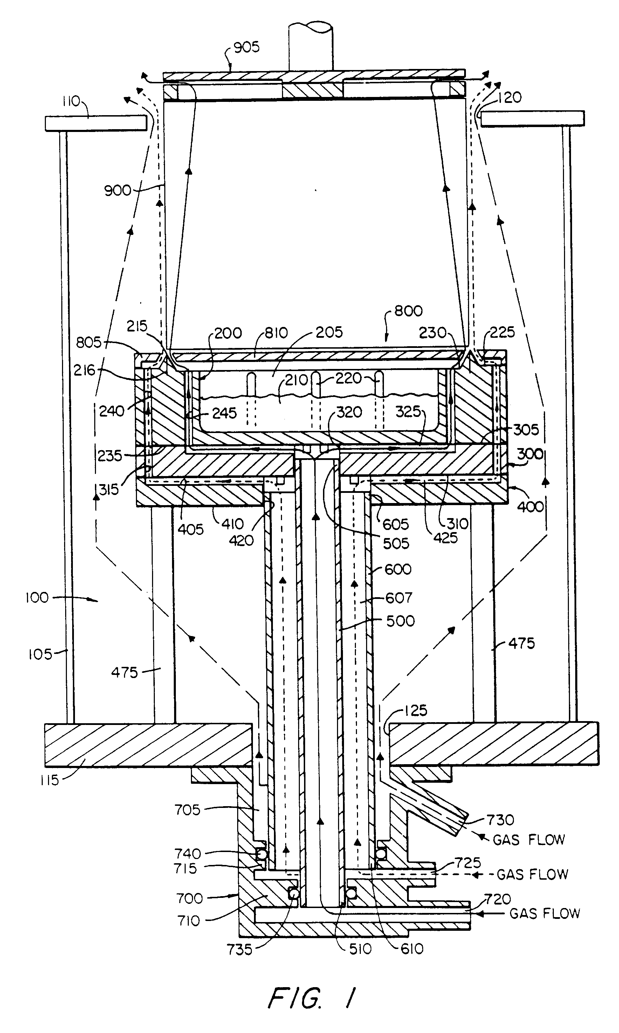

Looking first at Fig. 1, there is shown novel apparatus for growing tubular crystalline bodies from a melt. Although not shown, it is to be understood that the apparatus of Fig. 1 also includes associated apparatus such as heating coils, inner and outer after heater assemblies, insulation, etc. such as is normally found in a crystal growing furnace of the type disclosed in U.S. Patent No. 4440728. Such associated apparatus has now been omitted to facilitate understanding of the present invention.

The apparatus of Fig. 1 comprises a growth chamber 100 defined by a side wall 105, a top cover 110 and a chamber base 115. Top cover 110 has a center hole 120 formed therein, and chamber base 115 has a center hole 125 formed therein. Aperture 120 is axially aligned with aperture 125. Top aperture 120 preferably has a shape which, when looked at in plan view, is identical to the cross-sectional shape of the hollow crystalline body which is being grown in the apparatus, so that the hollow crystalline body issuing from the melt can pass through aperture 120 and make a reasonably close fit with the inner edges of top cover 110 which define its aperture 120, as will hereinafter be described in further detail. Center hole 125 preferably has a shape which, when looked at in plan view, is circular. The growth chamber's side wall 105, top cover 110 and chamber base 115 are fastened to one another so as to be as airtight as possible at their points of intersection, whereby center holes 120 and 125 constitute the portals into and out of growth chamber 100. Growth chamber 100 is formed out of those materials well known to those skilled in the art that are compatible with and do not react with the material of the hollow crystalline body that is being grown, e.g. side wall 105 is made of quartz, and top cover 110 and chamber base 115 are made of stainless steel where the growing crystalline body consists of silicon.

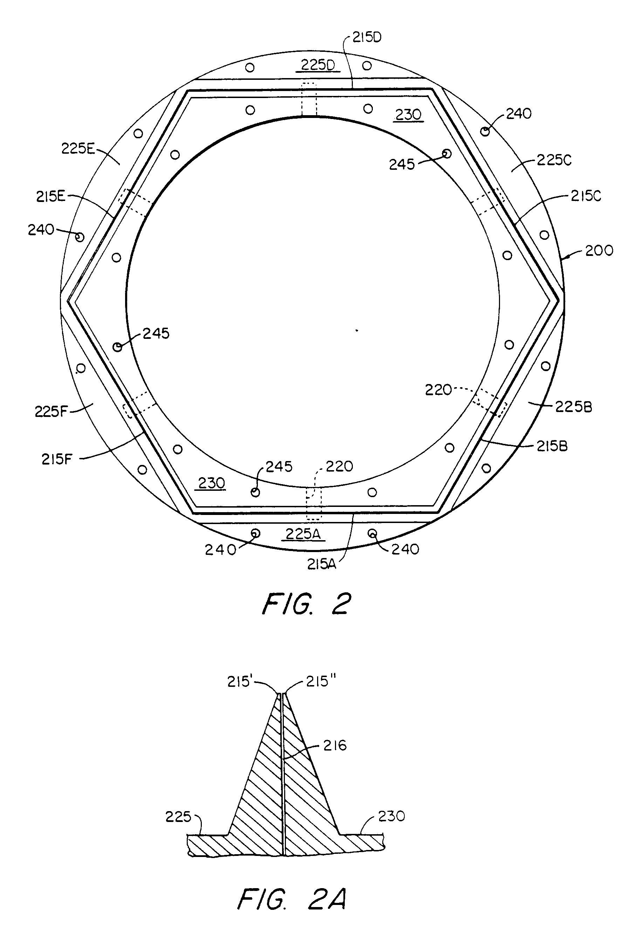

Crucible-die assembly 200 is disposed within growth chamber 100. Looking next at Figs. 1, 2 and 2A, crucible-die assembly 200 is similar to crucible-die assemblies well known in the art, but differs therefrom in specific features that are hereinafter described and illustrated in detail. More specifically, crucible-die assembly 200 comprises a central chamber 205 for receiving a melt 210 of the source material which is to be grown, a growth face 215 formed at the top of the crucible-die assembly, a capillary 216 that intersects growth face 215, and a plurality of capillary feed slots 220 formed in the walls of the crucible-die assembly for wetting growth face 215 with a liquid film of source material from melt 210.

Referring now to Fig. 2A, it is to be noted that growth face 215 actually comprises a pair of end surfaces or edges 215' and 215'' separated by a capillary opening 216. It is to be understood that liquid source material (i.e., the "melt") is transported via feed slots 220 and capillary 216 to growth face 215 by capillary action.

Crucible-die assembly 200 has its growth face 215 formed as a series of six abutting surfaces 215A, 215B, 215C, etc. (see Fig. 2), whereby a hollow tubular crystal of a hexagonal nature will be grown. Crucible-die assembly 200 has a pair of top surfaces disposed on either side of, and slightly below, growth face 215; an exterior top surface 225 (actually formed by six co-planar surfaces 225A, 225B, 225C, etc.) resides alongside growth face 215 exterior to the growth face, and an interior top surface 230 resides alongside growth face 215 interior to the growth face. As best seen in Fig. 1, top surfaces 225 and 230 sit below growth face 215 but sit above the top surface of melt 210. Crucible-die assembly 200 also includes a flat bottom surface 235. Crucible-die assembly 200 is formed out of materials well known to those skilled in the art, e.g. graphite.

The foregoing features of crucible-die assembly 200 are all believed to be well known to those skilled in the art. Crucible-die assembly 200 departs from conventional crucible-die assemblies in that it includes a plurality of exterior vertical passages 240 which extend between the crucible-die assembly's exterior top surface 225 and its bottom surface 235, and a plurality of interior vertical passages 245 which extend between the crucible-die assembly's interior top surface 230 and its bottom surface 235.

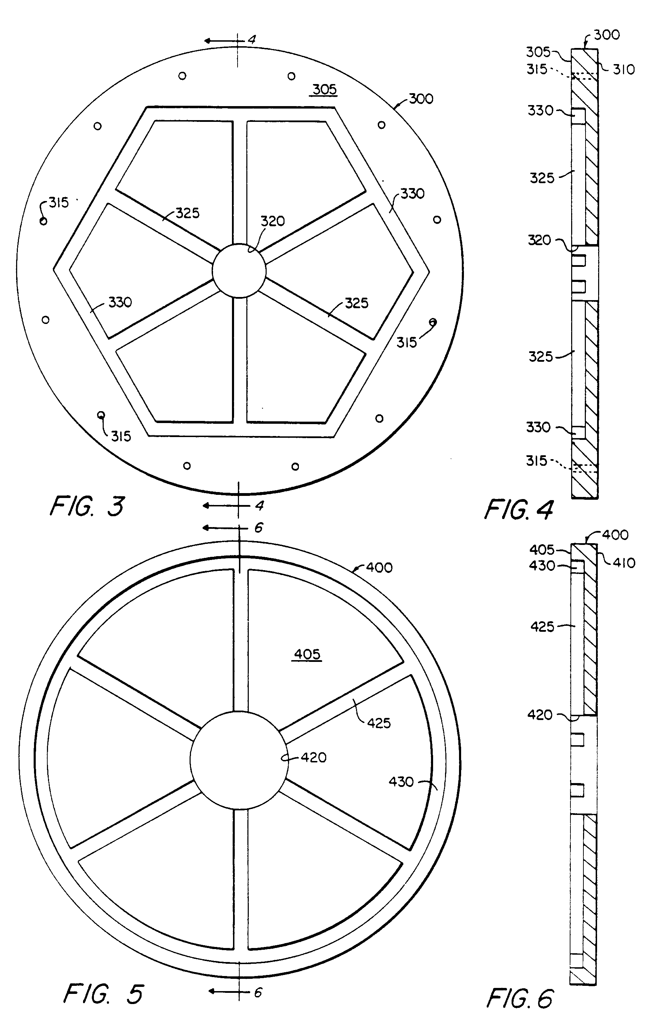

Crucible-die assembly 200 sits on an interior gas manifold plate 300. Looking next at Fig. 1, 3 and 4, interior gas manifold plate 300 comprises a disk or platter which has a flat top surface 305 and a flat bottom surface 310. Interior gas manifold 300 has a plurality of vertical passages 315 which extend between its top surface 305 and its bottom surface 310. Vertical passages 315 are sized and positioned so that they may be aligned with exterior vertical passages 240 formed in crucible-die assembly 200 when interior gas manifold plate 300 is positioned against the bottom surface of the crucible-die assembly, as will hereinafter be described in further detail. Interior gas manifold plate 300 also includes a central aperture 320 which extends between the plate's top surface 305 and its bottom surface 310. A plurality of surface grooves 325 are formed in top surface 305 of plate 300. Surface grooves 325 communicate with the plate's central aperture 320 and radiate outwardly so as to communicate with a hexagonally-shaped surface groove 330 also formed in the plate's top surface 305. Hexagonal surface groove 330 is sized and positioned so that it may be aligned with interior vertical passages 245 formed in crucible-die assembly 200 when interior gas manifold plate 300 is positioned against the bottom surface of the crucible-die assembly, as will hereinafter be described in further detail. Interior gas manifold plate is formed out of materials well known to those skilled in the art, e.g. graphite.

Interior gas manifold plate 300 in turn sits atop an exterior gas manifold plate 400. Looking next at Figs. 1, 5 and 6, exterior gas manifold plate 400 comprises a disk or platter having a flat top surface 405 and a flat bottom surface 410. Exterior gas manifold plate 400 has a central aperture 420 which extends between its top surface 405 and its bottom surface 410. A plurality of surface grooves 425 are formed in top surface 405 of plate 400. Surface grooves 425 communicate with the plate's central aperture 420 and radiate outwardly so as to communicate with a circular surface groove 430 also formed in the plate's top surface 405. Circular surface groove 430 is sized and positioned so that it may be aligned with vertical passages 315 formed in interior gas manifold plate 300 when exterior gas manifold plate 400 is positioned against the bottom surface of interior gas manifold plate 300, as will hereinafter be described in further detail. Exterior gas manifold plate 400 is formed out of materials well known to those skilled in the art, e.g. graphite.

Crucible-die assembly 200, interior gas manifold plate 300 and exterior gas manifold plate 400 are assembled together in the manner shown in Fig. 1, so that top surface 305 of interior gas manifold plate 300 is positioned against bottom surface 235 of crucible-die assembly 200, with vertical passages 315 of the interior gas manifold plate being aligned with exterior vertical passages 240 of the crucible-die assembly, and with surface grooves 325 of the interior gas manifold plate adjoining bottom surface 235 of the crucible-die assembly whereby bottom surface 235 forms a ceiling for surface grooves 325, and with surface grooves 325 of the interior gas manifold plate communicating with interior vertical passages 245 formed in the crucible-die assembly. In addition to the foregoing, top surface 405 of exterior gas manifold plate 400 is positioned against bottom surface 310 of interior gas manifold plate 300 so that central aperture 420 of the exterior gas manifold plate is axially aligned with central aperture 320 of interior gas manifold plate, and so that surface grooves 425 of the exterior gas manifold plate adjoin bottom surface 310 of the interior gas manifold plate whereby bottom surface 310 forms a ceiling for surface grooves 425, and so that surface grooves 425 of the exterior gas manifold plate communicate with vertical passages 315 formed in the interior gas manifold plate. As seen in Fig. 1, crucible-die assembly 200, interior gas manifold plate 300 and exterior gas manifold plate 400 are supported within growth chamber 100 by a plurality of posts 475 which extend between chamber base 115 and exterior gas manifold plate 400.

Still looking at Fig. 1, an interior gas feed tube 500 is attached to interior gas manifold plate 300 so that the feed tube's top end 505 forms an airtight fit with the walls of the manifold which define that manifold's central aperture 320. Interior gas feed tube 500 is attached to interior gas manifold plate 300 in the manner shown in Fig. 1 so that the feed tube's interior communicates with radial surface grooves 325 formed in interior manifold plate 300, whereby gases passed into the feed tube's lower end 510 will flow first into surface grooves 325 formed in the interior gas manifold plate and thereafter into internal vertical passages 245 formed in crucible-die assembly 200. Interior gas feed tube 500 is formed out of materials well known to those skilled in the art, e.g. graphite.

An exterior gas feed tube 600 is positioned concentrically around interior gas feed tube 500 and attached to exterior gas manifold plate 400 so that the exterior gas feed tube's top end 605 forms an airtight fit with the walls of the manifold which define that manifold's central aperture 420. This arrangement results in the creation of a chamber 607 between the concentric walls of the interior and exterior gas feed tubes. Exterior gas feed tube 600 is attached to exterior gas manifold plate 400 in the manner shown in Fig. 1 so that the aforementioned interior chamber 607 communicates with radial surface grooves 425 formed in exterior gas manifold plate 400, whereby gases passed into the feed tube's lower end 610 will flow first into surface grooves 425 formed in the exterior gas manifold plate, through vertical passages 315 formed into interior gas manifold plate 300, and thereafter into exterior vertical passages 240 formed in crucible-die assembly 200. Exterior gas feed tube 600 is formed out of materials well known to those skilled in the art, e.g. graphite.

Still looking at Fig. 1, the bottom ends of interior gas feed tube 500 and exterior gas feed tube 600 extend downward through bottom central aperture 125 formed in chamber base 115 and contact a gas fitting 700. Gas fitting 700 is disposed about bottom central aperture 125 and forms an airtight fit with chamber base 115. Gas fitting 700 is equipped with a central aperture 705, a first interior wall 710, a second interior wall 715, a first port 720, a second port 725 and a third port 730. Interior gas feed tube 500 is attached to gas fitting 700 so that the tube's second end 510 forms an airtight fit with an O-ring seal 735 disposed in a groove in first wall 710, whereby gases entering the fitting's first port 720 will be directed into the interior of interior gas feed tube 500. Exterior gas feed tube 600 is attached to gas fitting 700 so that the tube's second end 610 forms an airtight fit with an O-ring seal 740 disposed in a groove in second wall 715, whereby gases entering the fitting's second port 725 will be directed into the chamber 607 formed between the concentric interior and exterior gas feed tubes. On account of the fact that the outside dimension of exterior gas feed tube 600 is sized to be less than the dimension of bottom central aperture 125 of chamber base 115 and also less than the width of the gas fitting's central aperture 705, gases entering the fitting's third port 730 will be directed into the interior of growth chamber 100 but will be kept exterior to exterior gas feed tube 600 and crucible-die assembly 200. Gas fitting 700 is formed out of materials well known to those skilled in the art, e.g. stainless steel.

Still looking at Fig. 1, the novel apparatus for growing tubular crystalline bodies from a melt also includes gas directing means 800 disposed about the top end of crucible-die assembly 200. More specifically, gas directing means 800 comprises an exterior gas deflector 805 which sits atop the crucible-die assembly's exterior top surface 225 and which directs gases exiting from the top of exterior vertical passages 240 toward the crucible-die assembly's growth face 215, and an interior gas deflector 810 which sits atop the crucible-die assembly's interior top surface 230 and which directs gases exiting from the top of interior vertical passages 245 toward the crucible-die assembly's growth face 215. Exterior gas deflector 805 and interior gas deflector 810 are formed out of materials well known to those skilled in the art, e.g. graphite.

On account of the foregoing construction, when a hollow crystalline body 900 is being grown from a melt 210 according to the EFG process in ways well known in the art, gases directed into first port 720 of gas fitting 700 will make their way along the interior of interior gas feed tube 500, along surface grooves 325 formed in interior gas manifold plate 300, into interior vertical passages 245 formed in crucible-die assembly 200 and thereafter be deflected by interior gas deflector 810 against the interior surface of the hollow crystalline body issuing from die growth face 215. At the same time, gases directed into second port 725 of gas fitting 700 will make their way along chamber 607 formed between the concentric gas feed tubes 500 and 600, along surface grooves 425 formed in exterior gas manifold plate 400, into vertical passages 315 formed in interior gas manifold plate 300, along exterior vertical passages 240 formed in crucible-die assembly 200 and thereafter be deflected by exterior gas deflector 805 against the exterior surface of the hollow crystalline body issuing from die growth face 215. Finally, gases directed into third port 730 of gas fitting 700 will make their way through bottom central aperture 125 formed in chamber base 115 and into growth chamber 100.

It is to be appreciated that since top central aperture 120 of the growth chamber's top cover 110 is sized so as to be slightly larger than the crystalline body issuing from the melt, gases introduced into growth chamber 100 via the gas fitting's second port 725 and third port 730 will be able to escape from the growth chamber by passing through the small gap existing between the issuing crystalline body 900 and top cover 110. It is also to be appreciated that inasmuch as the seed holder 905 set at the top of the issuing hollow crystalline body 900 is not airtight, gases introduced into the interior of the growing crystalline body 900 via first port 720 will be able to escape from the interior of the issuing hollow crystalline body by passing through seed holder 905.

By way of example, suppose a hexagonal silicon tube of 20.32 cm (8 inch) diameter is to be grown at a rate of 2.54 cm (1 inch) per minute using the aforementioned apparatus, and the inert gas argon is to be introduced into growth chamber 100 via ports 720, 725 and 730 so as to purge the growth zone of any harmful reactive gases which might be present. In this case, port 720 might be used to introduce argon into the zone located inside the growing crystalline body (i.e., the "interior" zone), where the argon is introduced at a temperature of appoximately 30 degrees C. and is introduced at a rate of approximately 12000 cubic centimeters per minute; port 725 might be used to introduce argon into the zone located outside the growing crystalline body (i.e., the "exterior" zone), where the argon is introduced at a temperature of approximately 30 degrees C. and is introduced at a rate of approximately 12000 cubic centimeters per minute; and port 730 might be used to introduce argon into growth chamber 100, where the gas is introduced at a temperature of approximately 30 degrees C. and is introduced at a rate of approximately 16000 cubic centimeters per minute. The temperature of the growth face of the die is maintained at a temperature of between about 1410 and 1450 degrees C. during the growth procedure. The tubular crystalline product has a wall thickness of about 0.4 millimeters and its composition essentially comprises silicon.

While in the foregoing example inert argon gas was described as being introduced into ports 720 and 725 for the purpose of purging the growth zone of any harmful reactive gases which might be present, and inert argon gas was described as being introduced into port 730 for the purpose of providing an inert atmosphere within growth chamber 100, beneficial reactive gases such as oxygen, carbon monoxide, carbon dioxide, methane, etc. might be introduced into one or both of the ports 720 and 725 so as to introduce them into the growth zone, or port 730 so as to introduce them into growth chamber 100, or beneficial doping gases such as boron fluoride, phosphine, etc. might be introduced into one or both of the ports 720 and 725 so as to introduce them into the growth zone, or port 730 so as to introduce them into growth chamber 100.

The crucible-die assembly 200 could be formed so as to have more or less than the six abutting die surfaces 215A, 215B, 215C, etc. and the six co-planar exterior surfaces 225A, 225B, 225C, etc. described above, whereby a crystalline body of a different cross-sectional shape could be grown, e.g. crucible-die assembly 200 could be formed so as to have nine abutting die surfaces 215A, 215B, 215C, etc. and nine co-planar surfaces 225A, 225B, 225C, etc., whereby crystalline bodies of a nonagonal cross-section could be grown.

In the apparatus describe above, the vertical passages 240 and 245 carrying the gases inlet at ports 720 and 725, respectively, extend through the full height of the crucible-die assembly 200 before opening on faces 225 and 230. Such an arrangement is generally desirable since it allows the gases moving through passages 240 and 245 to pick up the heat of the melt and facilitates deploying the gases at the growth zone at the same temperature as the melt. However, in certain circumstances one might wish to deploy the gases at a temperature different than that of the melt. In this case one might place a layer of insulation around passages 240 and 245 to insulate the gases flowing through these passages from the temperature of the melt or, alternatively, one might even alter the positioning of passages 240 and 245 so that they extend horizontally through the crucible-die assembly, parallel to surfaces 225 and 230; such an arrangement could reduce the exposure of the gases passing through these passages from the heat of the crucible, although it would necessitate replacing the present means used to transport the gases from inlet ports 720 and 725 to passages 240 and 245 with some alternate means.

### Advantages of the Invention

One of the advantages of using the present invention is that the novel apparatus for growing tubular crystalline bodies includes means for controlling the atmosphere surrounding the growing crystalline body. As a result, harmful reactive gases can be removed from the area surrounding the growing crystalline body and inert gases, beneficial reactive gases and/or beneficial doping gases can be introduced to the area surrounding the growing crystalline body. In addition, by controlling the temperature of the atmosphere surrounding the growing crystalline body, proper regulation of the temperature of the growing crystalline body can be facilitated.

Another advantage of using the present invention is that means are provided for controlling the atmosphere surrounding the growing tubular crystalline body wherein the atmosphere in the zone located outside the growing crystalline body (i.e., the "exterior" zone) can be controlled independently of the atmosphere in the zone located inside the growing crystalline body (i.e., the "interior" zone). As a result, the exterior of the product crystalline body can be subjected to different growth conditions than the interior of the product crystalline body, if desired.

Another advantage of the present invention is that inasmuch as exterior vertical passages 240 and interior vertical passages 245 pass through the full height of the crucible-die assembly prior to opening adjacent to the crucible-die assembly's growth face, gases flowing upward through these passages to the growth face are allowed an opportunity to reach temperatures very close to that of the melt.

## Claims

1. An apparatus for use in a system for growing hollow crystalline bodies of a selected cross-sectional shape from a source material according to the EFG process, of the type comprising a crucible-die assembly (200) having means defining a crucible chamber (205) for containing a supply of liquid source material, means defining a growth face (215) for supporting a liquid film of source material for contact by a seed crystal for use in crystal growth, and means defining at least one capillary (216) for supplying liquid source material from the crucible chamber to the growth face so as to sustain said liquid film of source material by capillary action, the growth face when viewed in plan view having an annular configuration characterized by an interior edge (215'') and an exterior edge (215'), whereby a hollow tubular body may be grown from a liquid film of the source material on the growth face and support means (115, 475) for supporting the crucible-die assembly, characterized in that there is provided a first port associated with the support for defining a first gas inlet port (720) and a first passage (500, 325, 245) connected to the first port for directing gases introduced into the first port to the region adjacent the interior edge of the growth face, a second port for defining a second gas inlet port (725) and a second passage (600, 425, 315, 240) connected to the second port for directing gases introduced via the second port to the region adjacent the exterior edge of the growth face, whereby inner and outer surfaces of a hollow body being grown from the liquid film will be contacted by gases discharged from the first and second passages respectively, at least part of the first and second passages being formed in at least part of the crucible-die assembly.

2. An apparatus according to claim 1, characterized in that the crucible-die assembly comprises an interior top surface (230) adjacent to but separate from the interior edge, an exterior top surface (225) adjacent to but separate from the exterior edge and a bottom surface (235), the first passage comprises at least one passage (245) extending between the interior top surface and the bottom surface and the second passage comprises at least one passage (240) extending between the exterior top surface and the bottom surface, the first and second passages being formed separate from and not in communication with one another.

3. An apparatus according to claim 2, characterized in that at least one passage in the first passage and at least one passage in the second passage have discharge points at the top end of a side wall located so as to discharge one or more gases upwardly along the interior and along the exterior edges of the growth face, respectively.

4. An apparatus according to claim 3, characterized in that each of the passages is connected to its respective gas inlet port by a tubular member extending downward from the crucible-die assembly.

5. An apparatus according to any of the preceding claims, characterized in that there is provided a third port exterior of the crucible chamber for defining a third gas inlet port (730) remote from the crucible-die assembly and a third conduit connected to the third port for delivering a gas introduced via the third port to the space (100) surrounding the crucible-die assembly and the growing hollow body.

6. An apparatus according to any of claims 1 to 5, characterized in that there are included first (810) and second (805) concentric gas deflectors overlying the crucible-die assembly, the deflectors being adjacent to but spaced from the interior and exterior edge surfaces respectively of the die, whereby to cause gases discharged from the first and second gas discharge ports to flow upwardly along and in contact with the inner and outer edge surfaces and the interior and exterior surfaces respectivley of the growing crystalline body.

7. An apparatus according to any of claims 1 to 6, characterized in that the gas discharge ports of the first and second gas passageways are located below the growth face.

8. An apparatus according to any of claims 1 to 7, characterized in that the growth face has a polygonal configuration at its interior and exterior edges.

9. An apparatus according to any of claims 1 to 7, characterized in that the growth face has a hexagonal or nonagonal configuration at its interior and exterior edges.

10. An apparatus according to any of claims 1 to 9, characterized in that the first and second passage means are uniformly spaced about the center axis of the growth face.

## Patentansprüche

1. Vorrichtung zur Verwendung bei einem System zum Ziehen hohler kristalliner Körper einer ausgewählten Querschnittsgestalt aus einem Ausgangsmaterial gemäß dem EGF-("kantenbestimmtes, schmelzfilmbeschicktes Kristallzieh-") Verfahren, der Art die eine Schmelztiegel-Hohlform-Anordnung (200) umfaßt, die eine Einrichtung aufweist, die eine Schmelztiegelkammer (205) begrenzt, um einen Vorrat an flüssigem Ausgangsmaterial aufzunehmen, eine Einrichtung zur Begrenzung einer Wachstumsfläche (215) zum Stützen eines flüssigen Films des Ausgangsmaterials zur Berührung durch einen Keimkristall zur Verwendung beim Kristallziehen und eine Einrichtung, die mindestens eine Kapillare (216) zum Zuführen von flüssigem Ausgangsmaterial von der Schmelztiegelkammer zu der Wachstrnmsfläche begrenzt, um den Flüssigkeitsfilm des Ausgangsmaterials durch die Kapillarwirkung aufrechtzuerhalten, wobei die Wachstumsfläche wenn sie in Draufsicht betrachtet wird, eine ringförmige Konfiguration aufweist, gekennzeichnet durch eine Innenkante (215'') und eine Außenkante (215'), wodurch die ein hohler rohrförmiger Körper aus einem flüssigen Film des Ausgangsmaterials auf der Wachstumsfläche gezogen werden kann und Stützeinrichtungen (115, 475) zum Stützen der Schmelztiegel-Hohlform-Anordnung, dadurch gekennzeichnet, daß eine erste Öffnung vorgesehen ist, die dem Träger zur Begrenzung einer ersten Gaseinlaßöffnung (720) und eines ersten Durchlasses (500, 325, 245) zugeordnet ist, der mit der ersten Öffnung verbunden ist, um in die erste Öffnung eingeleitete Gase zu einem Bereich in der Nähe der Innenkante der Wachstumsfläche zu richten, eine zweite Öffnung zur Begrenzung einer zweiten Gaseinlaßöffnung (725) und eines zweiten Durchlasses (600, 425, 315, 240), der mit der zweiten Öffnung verbunden ist, um die über die zweite Öffnung eingeleiteten Gase zu einem Bereich in der Nähe der Außenkante der Wachstumsfläche zu richten, wodurch Innen- und Außenoberflächen eines Hohlkörpers, die aus dem flüssigen Film gezogen werden, durch aus dem ersten bzw. zweiten Durchlaß abgegebene Gase kontaktiert werden, wobei mindestens ein Teil der ersten und zweiten Durchlässe in mindestens einem Teil der Schmelztiegel-Hohlform-Anordnung gebildet sind.

2. Vorrichtung nach Anspruch 1, dadurch gekennzeichnet, daß die Schmelztiegel-Hohlform-Anordnung eine innere Oberseite (230) in der Nähe von, aber getrennt von der Innenkante, eine äußere Oberseite (225) in der Nähe von, aber getrennt von der Außenkante und eine Unterseite (235) umfaßt, der erste Durchlaß mindestens einen Durchlaß (245) umfaßt, der sich zwischen der inneren Oberseite und der Unterseite erstreckt und der zweite Durchlaß mindestens einen Durchlaß (240) umfaßt, der sich zwischen der äußeren Oberseite und der Unterseite erstreckt, wobei die ersten und zweiten Durchlässe getrennt von einander und nicht in Verbindung miteinander ausgebildet sind.

3. Vorrichtung nach Anspruch 2, dadurch gekennzeichnet, daß mindestens ein Durchlaß in dem ersten Durchlaß und mindestens ein Durchlaß in dem zweiten Durchlaß Abgabepunkte am oberen Ende einer Seitenwand aufweisen, die so angeordnet sind, um ein oder mehrere Gase nach oben entlang den Innen- bzw. entlang den Außenkanten der Wachstumsgläche abzugeben.

4. Vorrichtung nach Anspruch 3, dadurch gekennzeichnet, daß jeder der Durchlässe mit seiner jeweiligen Gaseinlaßöffnung durch ein rohrförmiges Element verbunden ist, das sich von der Schmelztiegel-Hohlform-Anordnung nach unten erstreckt.

5. Vorrichtung nach einem der vorhergehenden Ansprüche, dadurch gekennzeichnet, daß eine dritte Öffnung an der Außenseite der Schmelztiegelkammer angeordnet ist, um eine dritte Gaseinlaßöffnung (730) zu begrenzen, die von der Schmelztiegel-Hohlform-Anordnung abegelegen ist und ein dritter Kanal, der mit der dritten Öffnung verbunden ist, um ein durch die dritte Öffnung eingeleitetes Gas zu dem Raum (100) zu liefern, der die Schmelztiegel-Hohlform-Anordnung und den wachsenden Hohlkörper umgibt, vorgesehen sind.

6. Vorrichtung nach einem der Ansprüche 1 bis 5, dadurch gekennzeichnet, daß erste (810) und zweite (805) konzentrische Gasablenker vorgesehen sind, die über der Schmelztiegel-Hohlform-Anordnung liegen, wobei sich die Ablenker in der Nähe von, aber in einem Abstand von den Innen- bzw. Außenkantenoberflächen der Hohlform befinden, um dadurch zu bewirken, daß von den ersten und zweiten Gasaustrittsöffnungen abgegebene Gase nach oben entlang und in Berührung mit den Innen- und Außenkantenoberflächen bzw. den Innen- und Außenoberflächen des wachsenden, kristallinen Körpers strömen.

7. Vorrichtung nach einem der Ansprüche 1 bis 6, dadurch gekennzeichnet, daß die Gasaustrittsöffnungen dar ersten und zweiten Gasdurchlässe sich unterhalb der Wachstumsfläche befinden.

8. Vorrichtung nach einem der Ansprüche 1 bis 7, dadurch gekennzeichnet, daß die Wachstumsoberfläche an ihren Innen- und Außenkanten eine polygonale Konfiguration aufweist.

9. Vorrichtung nach einem der Ansprüche 1 bis 7, dadurch gekennzeichnet, daß die Wachstumsfläche eine sechseckige oder neuneckige Konfiguration an ihren Innen- und Außenkanten aufweist.

10. Vorrichtung nach einem der Ansprüche 1 bis 9, dadurch gekennzeichnet, daß die ersten und zweiten Durchlaßeinrichtungen gleichmäßig um die mittlere Achse der Wachstumsfläche herum im Abstand angeordnet sind.

## Revendications

1. Un dispositif destiné à être utilisé dans un système de croissance de corps cristallins creux à section de forme choisie à partir d'un matériau de source suivant le procédé CAS, du type comprenant un ensemble de creuset-matrice (200) présentant un moyen définissant une chambre de creuset (205) destinée à contenir une alimentation en matériau de source liquide, un moyen définissant une face de croissance (215) destinée à supporter un film liquide de matériau de source à mettre en contact avec un germe cristallin destiné à être utilisé dans la croissance de cristaux, et un moyen définissant au moins un capillaire (216) destiné à l'alimentation du matériau de source liquide de la chambre de creuset à la face de croissance, de manière à soutenir ledit film liquide de matériau de source par action capillaire, le face de croissance, lorsque vue en vue en plan, présentant une configuration annulaire, caractérisée par un bord intérieur (215'') et un bord extérieur (215'), un corps tubulaire creux pouvant être cultivé à partir d'un film liquide du matériau de source sur la face de croissance, et un moyen de support (115, 475) destiné à supporter l'ensemble de creuset-matrice, caractérisé en ce qu'il est prévu un premier orrifice associé au support, destiné à définir un premier orifice d'entrée de gaz (720) et un premier passage (500, 325, 245) raccordé au premier orifice, destiné à diriger les gaz introduits dans le premier orifice vers la zone adjacente au bord intérieur de la face de croissance, un second orifice destiné à définir un second orifice d'entrée de gaz (725) et un second passage (600, 425, 315, 240) raccordé au second orifice, destiné à diriger les gaz introduits par le second orifice vers la zone adjacente au bord extérieur de la face de croissance, les surfaces intérieure et extérieure d'un corps creux cultivés à partir du film liquide venant en contact avec des gaz évacués par les premier et second passages, respectivement, au moins une partie des premier et second passages étant formée dans au moins une partie de l'ensemble de creuset-matrice.

2. Un appareil suivant la revendication 1, caractérisé en ce que l'ensemble de creuset-matrice comprend une surface supérieure intérieure (230) adjacente au, mais séparée du bord intérieur, une surface supérieure extérieure (225) adjacente au, mais séparée du bord extérieur et une surface inférieure (235), que le premier passage comprend au moins un passage (245) s'étendant entre la surface supérieure intérieure et la surface inférieure et que le second passage comprend au moins un passage (240) s'étendant entre la surface supérieure extérieure et la surface inférieure, les premier et second passages étant formés séparés et non en communication l'un avec l'autre.

3. Un appareil suivant la revendication 2, caractérisé en ce qu'au moins un passage dans le premier passage et au moins un passage dans le second passage présentent des points d'évacuation à l'extrémité supérieure d'une paroi latérale situés de manière à évacuer un ou plusieurs gaz vers le haut, respectivement le long du bord intérieur et le long du bord extérieur de la face de croissance.

4. Un appareil suivant la revendication 3, caractérisé en ce que chacun des passages est raccordé, à son orifice d'entrée de gaz respectif, par un élément tubulaire s'étendant vers le bas depuis l'ensemble de creuset-matrice.

5. Un appareil suivant l'une ou l'autre des revendications précédentes, caractérisé cri ce qu'il est prévu un troisième orifice à l'extérieur de la chambre de creuset, destiné à définir un troisième orifice d'entrée de gaz (730) éloigné de l'ensemble de creuset-matrice et un troisième conduit raccordé au troisième orifice, destiné à alimenter un gaz introduit par le troisième orifice vers l'espace (100) entourant l'ensemble de creuset-matrice et le corps creux en croissance.

6. Un appareil suivant l'une ou l'autre des revendications 1 à 5, caractérisé en ce qu'il comporte des premier (810) et second (805) déflecteurs de gaz concentriques situés au-dessus de l'ensemble de creuset-matrice, les déflecteurs étant adjacents aux, mais séparés des surfaces de bord respectivement intérieur et extérieur de la matrice, faisant ainsi circuler les gaz évacués par les premier et second orifices d'évacuation vers le haut, le long des et en contact avec, respectivement, les surfaces de bord intérieur et extérieur et les surfaces intérieure et extérieure du corps cristallin en croissance.

7. Un appareil suivant l'une ou l'autre des revendications 1 à 6, caractérisé en ce que les orifices d'évacuation de gaz des premier et second passages de gaz sont situés au-dessous de la face de croissance.

8. Un appareil suivant l'une ou l'autre des revendications 1 à 7, caractérisé en ce que la face de croissance présente une configuration polygonale sur ses bords intérieur et extérieur.

9. Un appareil suivant l'une ou l'autre des revendications 1 à 7, caractérisé en ce que la face de croissance présente une configuration hexagonale ou nonagonale sur ses bords intérieur et extérieur.

10. Un appareil suivant l'une ou l'autre des revendications 1 à 9, caractérisé en ce que les premier et second moyens de passage sont uniformément distants par rapport à l'axe central de la face de croissance.
